# EUROPEAN PATENT SPECIFICATION

(11) **EP 3 710 265 B1**
(45) Date of publication and mention of the grant of the patent: **04.05.2022**
(21) Application number: 19706152.6
(22) Date of filing: 06.02.2019
(51) Int. Cl.: B41J 2/045

(54) **DELAY DEVICES**
VERZÖGERUNGSANORDNUNGEN
RELAIS RETARDS

(43) Date of publication of application: 23.09.2020
(73) Proprietor: HEWLETT-PACKARD DEVELOPMENT COMPANY, L.P., Spring, TX 77389 (US)
(72) Inventor: GARDNER, James M., Corvallis, Oregon 97330 (US); CORRIGAN, III, George H., Corvallis, Oregon 97330 (US); LINN, Scott A., Corvallis, Oregon 97330 (US)
(74) Representative: Haseltine Lake Kempner LLP
(86) International application number: PCT/US2019/016744
(87) International publication number: WO 2020/162901

(56) References cited:
- WO-A1-2016/068888
- WO-A1-2018/190858
- WO-A1-2019/013772

## Description

### Background

Printing devices can include printers, copiers, fax machines, multifunction devices including additional scanning, copying, and finishing functions, all-in-one devices, or other devices such as pad printers to print images on three dimensional objects and three-dimensional printers (additive manufacturing devices). In general, printing devices apply a print substance often in a subtractive color space or black to a medium via a device component generally referred to as a printhead. Printheads can employ fluid actuator devices, or simply actuator devices, to selectively eject droplets of print substance onto a medium during printing. For example, actuator devices can be used in inkjet type printing devices. A medium can include various types of print media, such as plain paper, photo paper, polymeric substrates and can include any suitable object or materials to which a print substance from a printing device are applied including materials, such as powdered build materials, for forming three-dimensional articles. Print substances, such as printing agents, marking agents, and colorants, can include toner, liquid inks, or other suitable marking material that in some examples may be mixed with other print substances such as fusing agents, detailing agents, or other materials and can be applied to the medium. WO2018/190858 describes delay elements for activation signals. WO2016/068888 describes a wide array printhead module. WO2019/013772 describes a fluidic die including actuators to eject fluid.

### Summary

The scope of the invention is defined by the appended claims.

### Brief Description of the Drawings

Figure 1 is a block diagram illustrating an example integrated circuit, which can be used to drive a plurality of actuators.
Figure 2 is a block diagram illustrating an example fluid ejection device that can include the example integrated circuit of Figure 1.
Figure 3 is a schematic diagram illustrating an example printing device that can include the example fluid ejection device of Figure 2.

### Detailed Description

An inkjet printing system, which is an example of a fluid ejection system, can include a printhead, a print substance supply, and an electronic controller. The printhead, which is an example of a fluidic actuator device or actuator device, can selectively eject droplets of print substance through a plurality of nozzles, each of which can be an example of an actuator, onto a medium during printing. The nozzles can be arranged on the printhead in a column or an array and the electronic controller can selectively sequence ejection of print substance. The printhead can include hundreds or thousands of nozzles, and each nozzle ejects a droplet of print substance in a firing event in which electrical power and actuation signals are provided to printhead. Each nozzle can consume tens of milliamperes (mA) of current during a firing event. The amount of electrical power required to simultaneously fire all nozzles on the printhead can exceed a current limit of the printing device, which can reduce print quality or cause substantial damage to the printhead.

Consequently, printheads often stagger the firing events to reduce peak power consumption during printing. Printheads typically employ digital circuits having flip-flops driven with a continuously running clock signal to stagger the firing events. In one example, firing events are staggered in the order of 100 nanoseconds apart. Each firing event can be triggered with a fire signal provided to each nozzle. The fire signal is provided from the digital circuit that may include a logic high, or a signal driven to a selected voltage, for approximately a microsecond to trigger the firing event or actuate the nozzle. Rather than simultaneously actuate hundreds or thousands of nozzles, the digital circuits may simultaneously actuate a dozen or so nozzles and substantially reduce peak current consumption, extend printhead life, as well as increase print efficiency.

As printheads and associated circuits get smaller, several circuit architectures are changed. These architecture adaptations have affected how the nozzles are fired and how the firing events are staggered. For example, the circuit architecture may no longer include a continuous running clock available to stagger firing events, and reductions to power routing and circuit area reduce the peak currents that can be tolerated by a printhead die.

This disclosure is directed to a circuit having a series of programmable analog delay elements that can stagger the fire signals provided to the fluid actuators. In one example, a fluid ejection device includes a first actuator and a second actuator that selectively eject a print substance in response to a fire signal. A first analog delay element is operably coupled in series with logic to receive the fire signal and a second analog delay element. The first analog delay element receives the fire signal and provides the fire signal to a first output after delay. The first output is coupled to the first actuator and the second analog delay element. The second analog delay element receives the fire signal from the first output and provides the fire signal to a second output after delay. The second output is operably coupled to the second actuator. A bias circuit is coupled to the first and second analog delay circuits to adjust the delay.

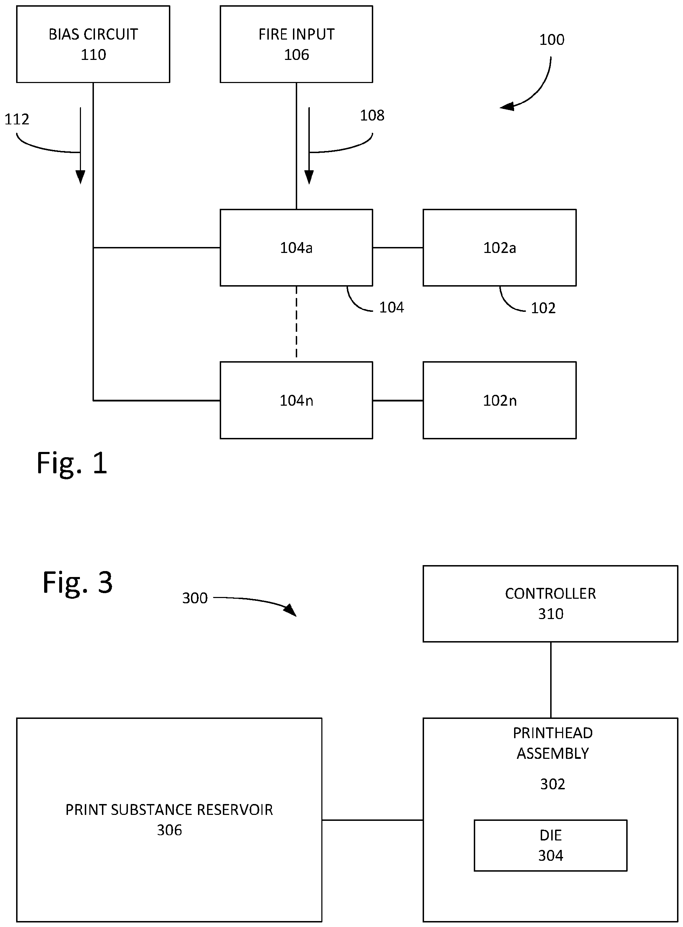

Figure 1 illustrates an example of an integrated circuit 100 to drive a plurality of fluid actuators 102. The plurality of fluid actuators 102 can include fluid actuators 102a...102n. The integrated circuit 100 includes a plurality of analog delay circuits 104, including analog delay circuits 104a...104n. Each of the analog delay circuits 104a...104n produces an output waveform similar to its input waveform but delayed by a selected amount of time. The plurality of analog delay circuits 104 are coupled together in series and to a fire input 106 to receive a fire signal 108. Each of the of the analog delay circuits 104a...104n of the plurality of analog delay circuits 104 receives the fire signal 108, and after a delay, provides the fire signal 108 via an output 114a...114n of a plurality of outputs 114 to a corresponding fluid actuator 102a...102n to trigger or actuate a firing event in the fluid actuator 102a...102n. For example, an analog delay circuit of the plurality of analog delay circuits 104 is coupled in series to a successive analog delay circuit of the plurality of analog delay circuits 104. The analog delay circuit receives the fire signal 108, and after a local delay, provides the fire signal 108 to a corresponding fluid actuator of the plurality of fluid actuators 102 and to the successive analog delay circuit. The successive analog delay circuit receives the fire signal 108, and, after a local delay provides the fire signal 108 to a corresponding fluid actuator of the plurality of fluid actuators 102. In one example, the fire signal 108 is a waveform having a logic voltage, such as a logic high voltage between about 1.8 volts and 15 volts, for a selected amount of time, such as 1 microsecond, to actuate a fluid actuator of the plurality of fluid actuators 102.

The integrated circuit 100 includes a bias circuit 110 operably coupled to each of the analog delay circuits 104a...104n. The bias circuit 110 provides a bias signal 112 to each of the analog delay circuits 104a... 104n to control the delay. In one example, the bias signal 112 can be a control voltage that provides an amount of delay in each of the analog delay circuits 104a... 104n to the fire signal 108 prior to the fire signal 108 provided at the output114a...114n. The control voltage of the bias signal 112 can be a continuous control voltage. In some examples, the bias signal 112 can be a control current, such as a continuous control current. The bias signal 112 provided to the analog delay circuits 104 can be selected from a plurality of bias signals that can be generated by the bias circuit 110. In this example, a length of the delay in an analog delay circuit 104 is variable. Each of the plurality of bias signals that can be provided to the analog delay circuits 104 can provide a different amount of delay in the analog delay circuits 104. In one example, a single bias signal 112 can be output from the bias circuit 110, but that single bias signal 112 can be selected from a plurality of available bias signals that can be generated by the bias circuit 110. The bias circuit 110 can programmably adjust a length of the delay of the analog delay circuits 104a...104n via the bias signal 112.

The analog delay circuits 104 are characterized by producing an output waveform similar to the input waveform, such as an input fire signal 108, but locally delayed by a selected amount of time. In general, this selected amount of time is variable and is based upon a selected input control voltage, such as a continuous control voltage. For instance, a first amount of continuous control voltage provides a first amount of delay and a second amount of continuous control voltage, which is different than the first amount of continuous control voltage, provides a second amount of delay that is different than the first amount of delay. In this example, the bias signal 112 provides the continuous control voltage. Example analog delay circuits 104 can employ a shunt capacitor technique, a current starved technique, or a variable resistor technique. In some examples, analog delay circuits 104 can be configured from cascaded delay circuit elements, such as a cascaded current starved inverter. An output of an analog delay circuit having current starved inverter circuit is provided as an input of a successive current starved inverter in a successive analog delay circuit. Analog delay circuits 104 are not characterized by receiving a free running clock signal.

In one example, each analog delay circuit 104a... 104n includes a current starved inverter circuit configured to receive a supply voltage *V_{DD}* and a bias signal 112 as control voltage *V_{CTRL}.* In one example, the current starved inverter circuit is configured to receive two simultaneous control voltages during operation. The bias signal 112 having a control voltage *V_{CTRL}* can include a plurality of control voltages such as control voltages *V_{CP}* and *V_{CN}*, during operation and to receive an input fire signal 108 on an input line. Each analog delay circuit 104a...104n is also configured to provide an output fire signal 108 on an output line. The control voltages *V_{CP}* and *V_{CN}* provided to the current starved inverter determine an amount of delay applied to the input fire signal prior to providing the output fire signal. For instance, an amount of difference between the control voltages *V_{CP}* and *V_{CN}* affects the amount of delay. A relatively larger difference between the control voltages *V_{CP}* and *V_{CN}* can provide a relatively longer delay, and a relatively smaller difference between the control voltages *V_{CP}* and *V_{CN}* can provide a relatively shorter delay. The bias circuit 110 provides the control voltages *V_{CP}* and *V_{CN}* from a programmable input. In one example, the bias circuit 110 includes a digital-to-analog converter to receive the programmable input and to output a corresponding bias signal 112 as a set of continuous control voltages *V_{CP}* and *V_{CN}*. In one example, the digital-to-analog converter is a five-bit digital-to-analog converter that can receive a five-bit digital signal as the programmable input and output one of thirty-two control voltage outputs, such as one of thirty-two control voltages *V_{CTRL}* or one of thirty-two sets of control voltages *V_{CP}* and *V_{CN}* to control an amount of delay of the analog delay circuits 104.

Compared to traditional delay circuits based on free running clock, analog delay circuits 104 self-generate delay of the fire signal 108. Each analog delay circuit 104a...104n, however, is susceptible to variations of delay due to combinations of voltage, temperature, silicon process speed, delay strength, and, in examples of the integrated circuits 100 used in printing systems, print density. In the example of printing systems, it has been discovered that such variations in delay are negligible in producing print substance drop placement and print quality. Bias circuit 110 is used to finely adjust delay of the analog delay circuits 104 as well as adjust delay for various print speed modes of a printhead system.

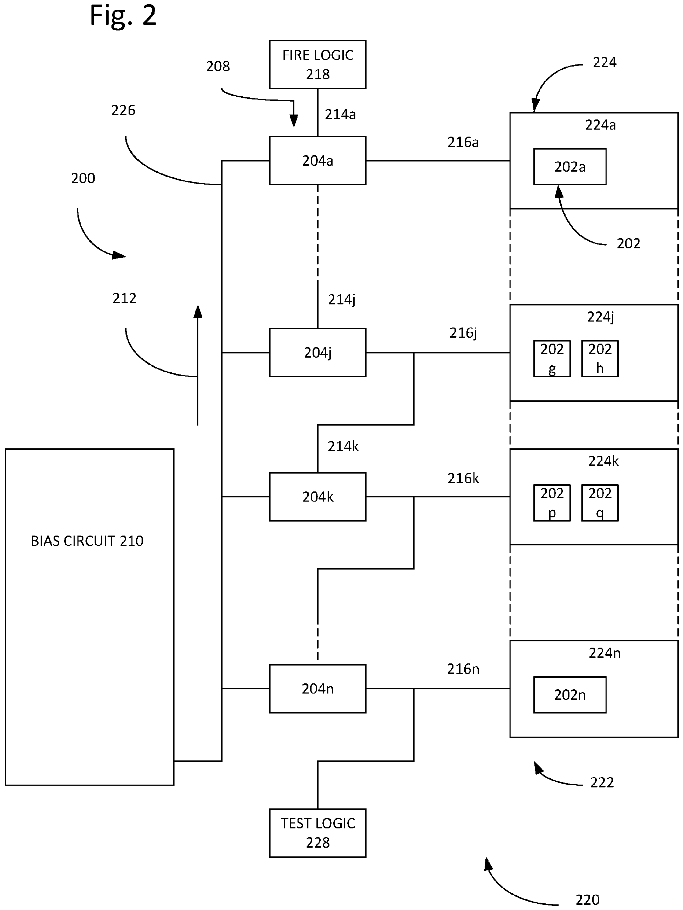

Figure 2 illustrates an example fluid ejection device 200 that can implement the example integrated circuit 100. One example of a fluid ejection device 200 can include a printhead system such as a printhead cartridge for a printing device. The printhead system can include an integrated printhead (IPH), such as a printhead integrated with a container of print substance, or the printhead system can include a printhead integrated with a printing device. Examples of the fluid ejection device 200 described with reference to a printhead system for ejecting a print substance are for illustration. The fluid ejection device 200 includes a plurality of fluid actuators 202, a plurality of analog delay circuits 204, and a bias circuit 210. The plurality of fluid actuators 202, plurality of analog delay circuits 204, and the bias circuit 210 can be included on a fluid ejection die 220 of the fluid ejection device 200. The fluid ejection device 200 can include the plurality of actuators 202 arranged as an actuator device 222 along a column of the fluid ejection die 220. In one example, the plurality of actuators 202 of the actuator device 222 can be configured to eject a print substance of a single color, such as a black print substance, and operably coupled to a print substance reservoir, which may be included on the fluid ejection device 200. The fluid ejection device 200 may include a plurality of dies in which each die is configured to eject a print substance from a set of print substances, such as print substances of a subtractive color space, and each die of the plurality of dice can be operably coupled to a print substance reservoir of a plurality of print substance reservoirs, which may be included on the fluid ejection device 200.

The plurality of analog delay circuits 204 are configured to drive the plurality of fluid actuators 202 with a fire signal 208, which triggers a firing event in the fluid actuators 202 to eject a fluid such as a print substance. Each of the fluid actuators 202a...202n corresponds with an analog delay circuit 204a...204n, and each fluid actuator 202a...202n is configured to receive the fire signal 208 from the corresponding analog delay circuit 204a...204n. In one example, the number of fluid actuators 202 may be different than the number of analog delay circuits 204. For instance, the number of fluid actuators 202 may be greater than the number of analog delay circuits 204, and an analog delay circuit 204 may correspond with a plurality of fluid actuators of the plurality of fluid actuators 202. The plurality of analog delay circuits 204 are also coupled together in series to pass the fire signal 208 from one analog delay circuit to another analog delay circuit. The fire signal 208 is locally delayed at each analog delay circuit 204 as it is passed through the plurality of analog delay circuits 204 in series. The bias circuit 210 provides a bias signal 212 to each of the plurality of analog delay circuits 204 to locally control an amount of delay of the fire signal 208 as the fire signal 208 is pass through the analog delay circuits 204. In one example, the bias circuit 210 can be operably coupled to the analog delay circuits 204 via line 226 to provide bias signal 212.

Each analog delay circuit 204a...204n can receive an input waveform on an input line and, after a delay, produce an output waveform on an output line. The analog delay circuits 204 are coupled together in series such that an output line of an analog delay circuit of a sequence is linked to the input line of a successive analog delay circuit of the sequence. The output waveform of each analog delay circuit 204a...204n is similar to the input waveform of the analog delay circuit but is locally delayed by a selected amount of time as controlled by the bias signal 212. In the illustration, the plurality of analog delay circuits 204 include first analog delay circuit 204j and second analog delay circuit 204k coupled together in series in a sequence. First analog delay circuit 204j includes a first input line 214j and first output line 216j. Second analog delay circuit 204k includes a second input line 214k and a second output line 216k. Second input line 214k is coupled to first output line 216j such that the second analog delay circuit 204k receives an input waveform provided as the output waveform from the first analog delay circuit 204j. An initial analog delay circuit 204a in the sequence includes an initial input line 214a operably coupled to a fire logic circuit 218, which can provide a fire signal 208 on input line 214a, and the fire signal 208 is sequentially passed through the analog delay elements 204 to a final output line 216n of a final analog delay circuit 204n.

In one example, the final output line 216n is coupled to test logic circuit 228. The test logic circuit 228 can receive the fire signal from the final analog delay circuit 204n and determine the total amount of delay of the fire signal 208 through the plurality of analog delay circuits 204. For example, the test logic circuit 228 can be coupled to the fire logic circuit 218 both directly and through the sequence of analog delay circuits 204, and the fire signals received from each coupling can be compared to determine the total amount of delay of the fire signal provided through the plurality of analog delay circuits 204. The total amount of delay can be measured and adjusted by programming the bias circuit 210 to adjust the bias signal 212. In one example, the bias circuit 210 can adjust the total amount of delay from between 1 microseconds to 5 microseconds, and an appropriate total amount of delay is selected based on a print mode speed of the ejection device 200. The total amount of delay can be selected to be short enough to allow the final analog delay circuit 204n to output a fire signal before a new fire signal is provided to the initial analog delay circuit 204a. Also, the total amount of delay can be selected to be long enough so that few analog delay circuits 204a...204n are simultaneously outputting fire signals 208 to the fluid actuators 202 to reduce peak currents from firing events. The total amount of delay can also be selected based on other factors such as rate of change of current per time, or ∂*i*/∂*t.* For example, longer delays can reduce peak currents that can decrease the rate of change of current per time, which can reduce current supply droop and electrical noise in the fluid ejection die 220.

Each fluid actuator 202a...202n is operably coupled to the output line 216a...216n of a corresponding analog delay circuit 204a...204n. In the illustrated example, a plurality of fluid actuators, such as fluid actuators 202g and 202h, are operably coupled to an output line of a corresponding analog delay circuit, such as output line 216j of analog delay circuit 204j. Also in the illustrated example, fluid actuators 202p and 202q are operably coupled to output line 216k of analog delay circuit 204k.

The plurality of actuators 202 can be arranged into a plurality of actuator primitives, or primitives 224, on the actuator device 222. For example, a selected number of proximate fluid actuators, such as fluid actuators 202g, 202h, can comprise a primitive 224j of the plurality of primitives 224. Primitive 224k can include fluid actuators 202p, 202q. The plurality of primitives 224 may be arranged along an axis of the column of the die 220 as primitives 224a to 224n. Each actuator 202 in a primitive 224 is assigned an address. In one example, each primitive 224 may include sixteen proximate fluid actuators 202 and the sixteen fluid actuators 202 on each primitive 224 can each be assigned an address from 0x0 to 0xF. In one example, one actuator 202 of a primitive 224 is selected at a time for ejecting a fluid as determined by the address. A controller can select the address and provide it to the primitives 224. (The controller can be located on the fluid ejection device 200 or can be remote from the fluid ejection device and provide a signal to the fluid ejection device 200 to select the address.) In one example, the selected address is applied to each primitive 224 on the actuator device 222. In this example, each analog delay circuit 204a...204n corresponds with a primitive 224a...224n, and each output line 216a...216n of a corresponding analog delay circuit 204a...204n is operably coupled to the corresponding primitive 224a...224n. For instance, each output line 216a...216n of a corresponding analog delay circuit 204a...204n is operably coupled to the fluid actuators 202 comprising the corresponding primitive 224a...224n. A fire signal 208 provided on the output line 216a...216n triggers a firing event in a fluid actuator 202 of the corresponding primitive 224 as selected by the address.

The fire signal 208 can be provided to the initial analog delay circuit 204a and passed through the plurality of analog delay circuits 204 and provided to primitives 224 to trigger firing events in the fluid actuators 202 corresponding with a selected address. For example, a fire signal 208 can be provided to input line 214j and analog delay circuit 204j can locally delay the fire signal 208 and provide the fire signal 208 on output line 216j to primitive 224j. In this example, a controller can select an address assigned to fluid actuator 202g of primitive 224j. Upon receiving the fire signal 208 at primitive 224j, a firing event is triggered in fluid actuator 202g to eject fluid from fluid actuator 202g. The fire signal 208 provided on output line 216j is also provided to input line 214k, and analog delay circuit 204k can locally delay the fire signal 208 and provide the fire signal 208 on output line 216k to primitive 224k. In this example, a controller can select an address assigned to fluid actuator 202p of primitive 224k. Upon receiving the fire signal 208 at primitive 224k, a firing event is triggered in fluid actuator 202p to eject fluid from fluid actuator 202p. In this example, after the fire signal 208 has been output from the final analog delay circuit 204n, the controller can select another address (such as the next address in sequence) and another fire signal can be provided to the initial analog delay circuit 204a and passed through the plurality of analog delay circuits 204 and provided to primitives 224.

Firing events in the primitives 224 are staggered as the fire signal 208 is passed through the sequence of analog delay circuits 204, and peak currents are reduced compared to simultaneously firing all primitives. The amount of peak current consumed in the die 220 can be selected by adjusting the amount of delay in the analog delay circuits 204 with the bias circuit 210. A long delay relatively reduces peak currents and a short delay relatively increases peak currents in the die 220 during the firing events.

Figure 3 illustrates an example printing device 300 that can employ the fluid ejection device 200 or integrated circuit 100. Printing device 300 includes a fluid ejection device, such as a printhead cartridge 302, which can be constructed in accordance with fluid ejection device 200 and include integrated circuit 100. Printhead cartridge 302 includes a fluid ejection die 304 to eject a print substance for printing or marking on media. The fluid ejection die 304 can be constructed in accordance with die 220. In one example, the printhead cartridge 302 includes a plurality of fluid ejection dice to eject a plurality of print substances, such as a print substances having color in the subtractive color space and a black print substance. The printing device 300 can include a print substance reservoir 306 to store and provide the print substance to the printhead cartridge 302. In one example, the print substance reservoir 306 can be included as part of the printhead cartridge 302. In another example, the print substance reservoir 306 can be remote from the printhead assembly 302 and may be operably coupled to the printhead cartridge 302 via tubing, valves, or pumps. In some examples, the print substance reservoir can include a refillable reservoir that may be filled with a print substance from a print substance supply.

Printing device 300 includes a controller 310 operably coupled to the printhead cartridge 302. The controller 310 can include a combination of hardware and programming such as firmware stored on a memory device. The controller 310 can receive signals regarding a file, such as a digital document, to be printed, and provide signals to the printhead cartridge 302. In one example, portions of the controller 310 can be distributed on hardware or programming throughout the printing device, and portions of the controller 310 can be included on printhead cartridge 302. In one example, the controller 310 can incorporate features of fire logic circuit 218 and test logic circuit 228. The controller 310 can provide signals to the actuator device 222 regarding address of fluid actuators 202 and can provide signals to the bias circuit 210 to program the bias signal 212. In one example, the controller 310 can receive signals from the analog delay circuits 204 to determine the status and health of components of the printhead cartridge 302. In one example, the printhead cartridge 302 can include conductive pads configured to mate with conductors on the printing device 300 such that the controller 310, or portions of the controller 310, can communicate with a printhead cartridge 302 that can be removably coupled to the printing device 300.

## Claims

1. An integrated circuit (100) to drive a plurality of fluid actuators (102, 202), the integrated circuit (100) comprising:
a plurality of delay circuits (104, 204) operably coupled in series and to a fire input (106) to receive a fire signal (108, 208) in succession, each delay circuit (104, 204) to receive the fire signal (108, 208) and, after a delay, provide the fire signal (108, 208) via an output to a corresponding fluid actuator (102, 202) of the plurality of fluid actuators (102, 202); and
a bias circuit (110, 210) operably coupled to each of the plurality of delay circuits (104, 20s4), the bias circuit (110, 210) to provide a bias signal (112, 212),
wherein the delay circuits (104, 204) are analog delay circuits (104, 204) **characterised in that** the bias signal (112, 212) is configured to adjust the delay for various print speed modes of a printhead system.

2. The integrated circuit (100) of claim 1 wherein each analog delay circuit (104, 204) includes a current starved inverter circuit.

3. The integrated circuit (100) of claim 1 or 2 wherein the bias circuit (110, 210) includes a digital-to-analog converter configured to receive a programmable input and the bias signal (112, 212) includes a control voltage in response to the programmable input.

4. The integrated circuit (100) of claim 3 wherein the control voltage is a continuous control voltage.

5. The integrated circuit (100) of claim 1 or 2 wherein the bias signal (112, 212) is one of a plurality of available bias signals that can be generated by the bias circuit (110, 210).

6. The integrated circuit (100) of claims 1-5 wherein each analog delay circuit (104, 204) includes an input, and the output of an analog delay circuit (104, 204) of the plurality of analog delay circuits (104, 204) is coupled to the input of a successive analog delay circuit (104, 204) coupled in series.

7. The integrated circuit (100) of claim 1 or 2 wherein a length of the delay is variable.

8. The integrated circuit (100) of claims 1-7 wherein the integrated circuit (100) is included on a fluid ejection die (220, 304).

9. A fluid ejection device (200), comprising:
a plurality of delay circuits (104, 204) operably coupled in series and to a fire input (106) to receive a fire signal (108, 208) in succession, each delay circuit (104, 204) to receive the fire signal (108, 208) and, after a delay, provide the fire signal (108, 208) via an output;
a bias circuit (110, 210) operably coupled to each of the plurality of delay circuits (104, 204), the bias circuit (110, 210) to provide a bias signal (112, 212) to control the delay; and
a fluid actuator (102, 202) device (222) having a plurality of fluid actuators (102, 202), the fluid actuator (102, 202) device (222) operably coupled to each output and to eject fluid with a fluid actuator (102, 202) of the plurality of the fluid actuators (102, 202) in response to the fire signal (108, 208),
wherein the delay circuits (104, 204) are analog delay circuits **characterised in that** the bias signal (112, 212) is configured to adjust the delay for various print speed modes of a printhead system.

10. The fluid ejection device (200) of claim 9 wherein the plurality of analog delay circuits (104, 204), the bias circuit (110, 210), and the fluid actuator (102, 202) device (222) are included on a fluid ejection die (220, 304).

11. The fluid ejection device (200) of claim 10 comprising a plurality of fluid ejection dice.

12. The fluid ejection device (200) of claim 10 or 11 comprising a print substance reservoir (306).

13. A printhead cartridge (302) comprising the integrated circuit (100) according to claim 1, wherein the integrated circuit (100) according to claim 1 is configured to drive a plurality of fluid actuators (102, 202), the integrated circuit (100) further comprising:
a plurality of fluid actuators (102, 202), each of the plurality of fluid actuators (102, 202) being operably coupled to a corresponding output and being configured to eject fluid in response to the fire signal (108, 208).

14. The printhead cartridge (302) of claim 13 wherein the plurality of fluid actuators (102, 202) are arranged in a plurality of primitives (224), and each primitive (224) is coupled to a corresponding output.

15. The printhead cartridge (302) of claim 14 wherein the plurality of primitives (224) are arranged on a fluid ejection die (220, 304) along an axis of a column of the fluid ejection die (220, 304).

## Patentansprüche

1. Integrierte Schaltung (100), um mehrere Fluidaktuatoren (102, 202) anzutreiben, wobei die integrierte Schaltung (100) Folgendes umfasst:
mehrere Verzögerungsschaltungen (104, 204), die in Reihe und mit einer Abfeuerungseingabe (106) wirkgekoppelt sind, um nacheinander ein Abfeuerungssignal (108, 208) zu empfangen, wobei jede Verzögerungsschaltung (104, 204) das Abfeuerungssignal (108, 208) empfängt und nach einer Verzögerung das Abfeuerungssignal (108, 208) über eine Ausgabe an einen entsprechenden Fluidaktuator (102, 202) der mehreren Fluidaktuatoren (102, 202) bereitstellt; und
eine Vorspannungsschaltung (110, 210), die mit jeder der mehreren Verzögerungsschaltungen (104, 20s4) wirkgekoppelt ist, wobei die Vorspannungsschaltung (110, 210) ein Vorspannungssignal (112, 212) bereitstellt,
wobei die Verzögerungsschaltungen (104, 204) analoge Verzögerungsschaltungen (104, 204) sind, **dadurch gekennzeichnet, dass** das Vorspannungssignal (112, 212) dazu konfiguriert ist, die Verzögerung für verschiedene Druckgeschwindigkeitsmodi eines Druckkopfsystems einzustellen.

2. Integrierte Schaltung (100) nach Anspruch 1, wobei jede analoge Verzögerungsschaltung (104, 204) eine stromreduzierte Wechselrichterschaltung beinhaltet.

3. Integrierte Schaltung (100) nach Anspruch 1 oder 2, wobei die Vorspannungsschaltung (110, 210) einen Digital-Analog-Wandler beinhaltet, der dazu konfiguriert ist, eine programmierbare Eingabe zu empfangen, und das Vorspannungssignal (112, 212) eine Steuerspannung als Reaktion auf die programmierbare Eingabe beinhaltet.

4. Integrierte Schaltung (100) nach Anspruch 3, wobei die Steuerspannung eine fortlaufende Steuerspannung ist.

5. Integrierte Schaltung (100) nach Anspruch 1 oder 2, wobei das Vorspannungssignal (112, 212) eines von mehreren verfügbaren Vorspannungssignalen ist, die durch die Vorspannungsschaltung (110, 210) erzeugt werden können.

6. Integrierte Schaltung (100) nach den Ansprüchen 1-5, wobei jede analoge Verzögerungsschaltung (104, 204) eine Eingabe beinhaltet und die Ausgabe einer analogen Verzögerungsschaltung (104, 204) der mehreren analogen Verzögerungsschaltungen (104, 204) mit der Eingabe einer nachfolgenden analogen Verzögerungsschaltung (104, 204) gekoppelt ist, die in Reihe gekoppelt ist.

7. Integrierte Schaltung (100) nach Anspruch 1 oder 2, wobei eine Länge der Verzögerung variabel ist.

8. Integrierte Schaltung (100) nach den Ansprüchen 1-7, wobei die integrierte Schaltung (100) auf einer Fluidausstoßdüse (220, 304) beinhaltet ist.

9. Fluidausstoßvorrichtung (200), die Folgendes umfasst:
mehrere Verzögerungsschaltungen (104, 204), die in Reihe und mit einer Abfeuerungseingabe (106) wirkgekoppelt sind, um nacheinander ein Abfeuerungssignal (108, 208) zu empfangen, wobei jede Verzögerungsschaltung (104, 204) das Abfeuerungssignal (108, 208) empfängt und nach einer Verzögerung das Abfeuerungssignal (108, 208) über eine Ausgabe bereitstellt;
eine Vorspannungsschaltung (110, 210), die mit jeder der mehreren Verzögerungsschaltungen (104, 204) wirkgekoppelt ist, wobei die Vorspannungsschaltung (110, 210) ein Vorspannungssignal (112, 212), um die Verzögerung zu steuern, bereitstellt; und
eine Fluidaktuator (102, 202) vorrichtung (222), die mehrere Fluidaktuatoren (102, 202) aufweist, wobei die Fluidaktuator (102, 202) vorrichtung (222) mit jeder Ausgabe wirkgekoppelt ist und Fluid mit einem Fluidaktuator (102, 202) der mehreren Fluidaktuatoren (102, 202) als Reaktion auf das Abfeuerungssignal (108, 208) ausstoßt,
wobei die Verzögerungsschaltungen (104, 204) analoge Verzögerungsschaltungen sind, **dadurch gekennzeichnet, dass** das Vorspannungssignal (112, 212) dazu konfiguriert ist, die Verzögerung für verschiedene Druckgeschwindigkeitsmodi eines Druckkopfsystems einzustellen.

10. Fluidausstoßvorrichtung (200) nach Anspruch 9, wobei die mehreren analogen Verzögerungsschaltungen (104, 204), die Vorspannungsschaltung (110, 210) und die Fluidaktuator (102, 202) vorrichtung (222) in einer Fluidausstoßdüse (220, 304) beinhaltet sind.

11. Fluidausstoßvorrichtung (200) nach Anspruch 10, die mehrere Fluidausstoßdüsen umfasst.

12. Fluidausstoßvorrichtung (200) nach Anspruch 10 oder 11, die ein Drucksubstanzreservoir (306) umfasst.

13. Druckkopfkartusche (302), die die integrierte Schaltung (100) nach Anspruch 1 umfasst, wobei die integrierte Schaltung (100) nach Anspruch 1 dazu konfiguriert ist, mehrere Fluidaktuatoren (102, 202) anzutreiben, wobei die integrierte Schaltung (100) ferner Folgendes umfasst:
mehrere Fluidaktuatoren (102, 202), wobei jeder der mehreren Fluidaktuatoren (102, 202) mit einer entsprechenden Ausgabe wirkgekoppelt ist und dazu konfiguriert ist, Fluid als Reaktion auf das Abfeuerungssignal (108, 208) auszustoßen.

14. Druckkopfkartusche (302) nach Anspruch 13, wobei die mehreren Fluidaktuatoren (102, 202) in mehrere Primitive (224) angeordnet sind und jedes Primitiv (224) mit einer entsprechenden Ausgabe gekoppelt ist.

15. Druckkopfkartusche (302) nach Anspruch 14, wobei die mehreren Primitive (224) auf einer Fluidausstoßdüse (220, 304) entlang einer Achse einer Spalte der Fluidausstoßdüse (220, 304) angeordnet sind.

## Revendications

1. Circuit intégré (100) destiné à entraîner une pluralité d'actionneurs de fluide (102, 202), le circuit intégré (100) comprenant :
une pluralité de circuits de retard (104, 204) couplés de manière fonctionnelle en série et à une entrée de déclenchement (106) pour recevoir un signal de déclenchement (108, 208) successivement, chaque circuit de retard (104, 204) devant recevoir le signal de déclenchement (108, 208) et, après un délai, fournir le signal de déclenchement (108, 208) par l'intermédiaire d'une sortie à un actionneur à fluide correspondant (102, 202) de la pluralité d'actionneurs à fluide (102, 202) ; et
un circuit de polarisation (110, 210) couplé de manière fonctionnelle à chacun de la pluralité de circuits de retard (104, 20s4), le circuit de polarisation (110, 210) pour fournir un signal de polarisation (112, 212),
dans lequel les circuits de retard (104, 204) sont des circuits de retard analogiques (104, 204) **caractérisés en ce que** le signal de polarisation (112, 212) est configuré pour régler le retard pour différents modes de vitesse d'impression d'un système de tête d'impression.

2. Circuit intégré (100) selon la revendication 1, dans lequel chaque circuit de retard analogique (104, 204) comporte un circuit inverseur privé de courant.

3. Circuit intégré (100) selon la revendication 1 ou 2, dans lequel le circuit de polarisation (110, 210) comporte un convertisseur numérique-analogique configuré pour recevoir une entrée programmable et le signal de polarisation (112, 212) comporte une tension de commande en réponse à l'entrée programmable.

4. Circuit intégré (100) selon la revendication 3, dans lequel la tension de commande est une tension de commande continue.

5. Circuit intégré (100) selon la revendication 1 ou 2, dans lequel le signal de polarisation (112, 212) est l'un d'une pluralité de signaux de polarisation disponibles qui peuvent être générés par le circuit de polarisation (110, 210).

6. Circuit intégré (100) selon les revendications 1 à 5, dans lequel chaque circuit de retard analogique (104, 204) comporte une entrée et la sortie d'un circuit de retard analogique (104, 204) de la pluralité de circuits de retard analogiques (104, 204) est couplée à l'entrée d'un circuit de retard analogique successif (104, 204) couplé en série.

7. Circuit intégré (100) selon la revendication 1 ou 2, dans lequel une durée du retard est variable.

8. Circuit intégré (100) selon les revendications 1 à 7, dans lequel le circuit intégré (100) est inclus sur une matrice d'éjection de fluide (220, 304).

9. Dispositif d'éjection de fluide (200) comprenant :
une pluralité de circuits de retard (104, 204) couplés de manière fonctionnelle en série et à une entrée de déclenchement (106) pour recevoir un signal de déclenchement (108, 208) successivement, chaque circuit de retard (104, 204) devant recevoir le signal de déclenchement (108, 208) et, après un délai, fournir le signal de déclenchement (108, 208) par l'intermédiaire d'une sortie ;
un circuit de polarisation (110, 210) couplé de manière fonctionnelle à chacun de la pluralité de circuits de retard (104, 204), le circuit de polarisation (110, 210) devant fournir un signal de polarisation (112, 212) pour commander le retard ; et
un dispositif (222) d'actionneur de fluide (102, 202) ayant une pluralité d'actionneurs de fluide (102, 202), le dispositif (222) d'actionneur de fluide (102, 202) étant accouplé de manière fonctionnelle à chaque sortie et devant éjecter du fluide au moyen d'un actionneur de fluide (102, 202) de la pluralité d'actionneurs à fluide (102, 202) en réponse au signal de déclenchement (108, 208),
dans lequel les circuits de retard (104, 204) sont des circuits de retard analogiques **caractérisés en ce que** le signal de polarisation (112, 212) est configuré pour régler le retard pour différents modes de vitesse d'impression d'un système de tête d'impression.

10. Dispositif d'éjection de fluide (200) selon la revendication 9, dans lequel la pluralité de circuits de retard analogiques (104, 204), le circuit de polarisation (110, 210) et le dispositif (222) d'actionneur de fluide (102, 202) sont inclus sur une matrice d'éjection de fluide (220, 304).

11. Dispositif d'éjection de fluide (200) selon la revendication 10 comprenant une pluralité de dés d'éjection de fluide.

12. Dispositif d'éjection de fluide (200) selon la revendication 10 ou 11, comprenant un réservoir de substance d'impression (306).

13. Cartouche de tête d'impression (302) comprenant le circuit intégré (100) selon la revendication 1, dans laquelle le circuit intégré (100) selon la revendication 1 est configuré pour entraîner une pluralité d'actionneurs de fluide (102, 202), le circuit intégré (100) comprenant en outre :
une pluralité d'actionneurs de fluide (102, 202), chacun de la pluralité d'actionneurs de fluide (102, 202) étant accouplé de manière fonctionnelle à une sortie correspondante et étant configuré pour éjecter du fluide en réponse au signal de déclenchement (108, 208).

14. Cartouche de tête d'impression (302) selon la revendication 13, dans laquelle la pluralité d'actionneurs de fluide (102, 202) est agencée en une pluralité de primitives (224), et chaque primitive (224) est couplée à une sortie correspondante.

15. Cartouche de tête d'impression (302) selon la revendication 14, dans laquelle la pluralité de primitives (224) sont disposées sur une matrice d'éjection de fluide (220, 304) le long d'un axe d'une colonne de la matrice d'éjection de fluide (220, 304).
